# EUROPEAN PATENT APPLICATION

(11) **EP 4 629 775 A1**
(43) Date of publication of application: **08.10.2025**
(21) Application number: 24186815.7
(22) Date of filing: 05.07.2024
(51) Int. Cl.: H10D 62/10, H10D 62/832

(54) **SILICON CARBIDE POWER DEVICE AND MANUFACTURING METHOD OF THE SAME**

(30) Priority: 01.04.2024 TW 113112356
(71) Applicant: Hon Hai Precision Industry Co., Ltd., 236 New Taipei City (TW)
(72) Inventor: YU, Wei-Cheng, 236 New Taipei City (TW); HUNG, Chia-Lung, 236 New Taipei City (TW); HSIAO, Yi-Kai, 236 New Taipei City (TW); KUO, Hao-Chung, 236 New Taipei City (TW)
(74) Representative: Becker, Eberhard

(57) **Abstract**

A silicon carbide power device includes a silicon carbide substrate (100, 300), a plurality of first ion implantation regions (102, 310), a plurality of dielectric trench structures (104), and a plurality of second ion implantation regions (106, 314). The first ion implantation regions (102, 310) are distributed on a surface of the silicon carbide substrate (100, 300) in a termination region (10b). The dielectric trench structures (104) are disposed in the silicon carbide substrate (100, 300) among the first ion implantation regions (102, 310), so that the dielectric trench structures (104) and the first ion implantation regions (102, 310) are alternately arranged along a horizontal direction (D1). The second ion implantation regions (106, 314) are respectively disposed at the bottoms of the dielectric trench structures (104).

## Description

### BACKGROUND

### Technical Field

The disclosure relates to a power device technology, and in particular to a silicon carbide power device and a manufacturing method of the same.

### Description of Related Art

In response to the rise of electric vehicles, the silicon carbide device technology is developing in the direction of high voltage and high current, and improving the voltage endurance of silicon carbide devices has always been a goal of all fields.

For example, in vertical silicon carbide devices, voltage breakdown often occurs because the high potential difference between the source side doped well and the drain below creates a huge electric field.

At present, a common improvement method is to increase the number of guard rings toward a horizontal direction. However, blindly increasing the number of guard rings rises the horizontal size and limits the effect of avoiding voltage breakdown. The reason is that in the voltage endurance structure of the silicon carbide device, in addition to the guard ring, there is also a junction termination extension (JTE) between the guard ring and the active region, and the ion concentration in the JTE is higher than the guard ring, and is closer to the active region to withstand a larger proportion of voltage division. If the total length of the guard ring region is continuously extended, the effect may be limited because the guard rings are too far away from the JTE.

### SUMMARY

The disclosure provides a silicon carbide power device which can effectively improve a characteristic of the voltage endurance of the device while increasing the limited size.

The disclosure also provides a manufacturing method of a silicon carbide power device, which can manufacture the silicon carbide power device by a self-aligned method.

A silicon carbide power device of the disclosure includes a silicon carbide substrate, multiple first ion implantation regions, multiple dielectric trench structures, and multiple second ion implantation regions. The aforementioned silicon carbide power device has an active region and a termination region, and the first ion implantation regions are distributed on a surface of the silicon carbide substrate in the termination region. The dielectric trench structures are disposed in the silicon carbide substrate among the plurality of first ion implantation regions, so that the plurality of dielectric trench structures and the plurality of first ion implantation regions are alternately arranged along a horizontal direction. The second ion implantation regions are respectively disposed at bottoms of the dielectric trench structures.

Another silicon carbide power device of the disclosure includes a silicon carbide substrate, multiple first guard rings, multiple of second guard rings, and multiple dielectric trench structures. The aforementioned silicon carbide power device has an active region and a termination region, the first guard rings are disposed on a surface of the silicon carbide substrate in the termination region, and the second guard rings are disposed in the silicon carbide substrate among the plurality of first guard rings, where the plurality of first guard rings and the plurality of second guard rings are located on different horizontal planes. The dielectric trench structures are disposed above the second guard rings and alternately arranged with the first guard rings.

The manufacturing method of the silicon carbide power device of the disclosure includes providing a silicon carbide substrate; forming a first mask layer on a surface of the silicon carbide substrate, where the first mask layer has multiple first trenches exposing part of the surface; forming multiple first ion implantation regions in the exposed surface; forming a second mask layer filling the first trenches on the first mask layer; removing part of the second mask layer until the first mask layer is exposed; removing the first mask layer completely, leaving the second mask layer to expose the surface among the first ion implantation regions; using the second mask layer as an etch mask, and removing the exposed surface to form multiple self-aligned second trenches among the first ion implantation regions; forming multiple second ion implantation regions in the silicon carbide substrate at bottoms of the of second trenches; and filling a dielectric material in the second trenches.

Based on the above, the disclosure improves the electric field balance in the vertical direction to increase the depletion area, and uses a self-aligned trench etching process to form the guard rings with upper and lower layers distributed alternately. Therefore, the disclosure increases the number of guard rings in a limited size and makes the ion implantation reach a deeper vertical direction, so that the overall electric field distribution is more uniform to improve the characteristic of the voltage endurance of the device.

In order to make the aforementioned features and advantages of the disclosure comprehensible, embodiments accompanied with drawings are described in detail below.

### BRIEF DESCRIPTION OF THE DRAWINGS

FIG. 1 is a schematic cross-sectional view of a silicon carbide power device according to a first embodiment of the disclosure.
FIG. 2 is a schematic three-dimensional view of a silicon carbide power device according to a second embodiment of the disclosure.
FIG. 3A to FIG. 3J are schematic cross-sectional views of a manufacturing process of a silicon carbide power device according to a third embodiment of the disclosure.

### DESCRIPTION OF THE EMBODIMENTS

The embodiments are described in detail below with reference to the accompanying drawing, but the provided embodiments are not intended to limit the scope of the disclosure. In addition, sizes of the regions and film layers in the drawing are drawn for the convenience of description, and are not drawn according to original sizes.

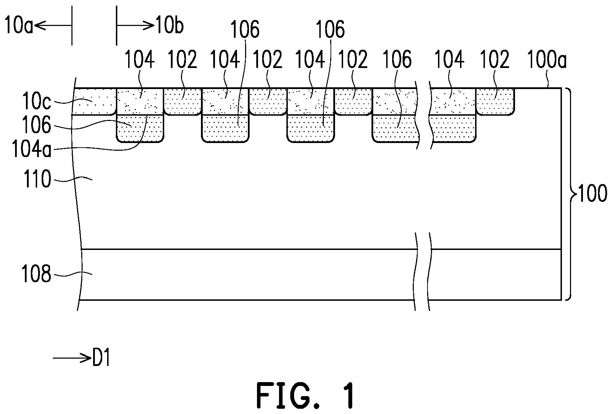

FIG. 1 is a schematic cross-sectional view of a silicon carbide power device according to a first embodiment of the disclosure.

Referring to FIG. 1, the silicon carbide power device of the first embodiment has an active region 10a and a termination region 10b. The active region 10a generally has devices (not shown) such as power transistors while the termination region 10b surrounds the active region 10a and makes an electric field distribution below decrease evenly by design. In addition, a junction termination extension (JTE) region 10c may be disposed between the active region 10a and the termination region 10b to accurately control a drift layer charge of a junction termination. The silicon carbide power device of the first embodiment basically includes a silicon carbide substrate 100, multiple first ion implantation regions 102, multiple dielectric trench structures 104, and multiple second ion implantation regions 106. The silicon carbide substrate 100 is a first conductivity type, and the first ion implantation region 102 and the second ion implantation region 106 are a second conductivity type. In an embodiment, the first conductivity type is an N-type, and the second conductivity type is a P-type. In another embodiment, the first conductivity type is the P-type, and the second conductivity type is the N-type. The silicon carbide substrate 100 is generally composed of an N+ silicon carbide substrate 108 and an N- silicon carbide epitaxial layer 110 formed thereon, but the disclosure is not limited thereto. The first ion implantation region 102 is distributed on a surface 100a of the silicon carbide substrate 100 in the termination region 10b. The dielectric trench structures 104 are disposed in the silicon carbide substrate 100 among the first ion implantation regions 102, so that the dielectric trench structures 104 and the first ion implantation regions 102 are alternately arranged along a horizontal direction D1, where a material of the dielectric trench structures 104 may be a high-k dielectric material, or a material of the dielectric trench structures 104 may be an oxide or a nitride, such as silicon oxide. Compared with the N- silicon carbide epitaxial layer 110, the dielectric trench structure 104 further provides insulation and structural stability. The second ion implantation regions 106 are respectively disposed at the bottoms 104a of the dielectric trench structures 104. Therefore, the first ion implantation regions 102 and the second ion implantation regions 106 are located on different horizontal planes.

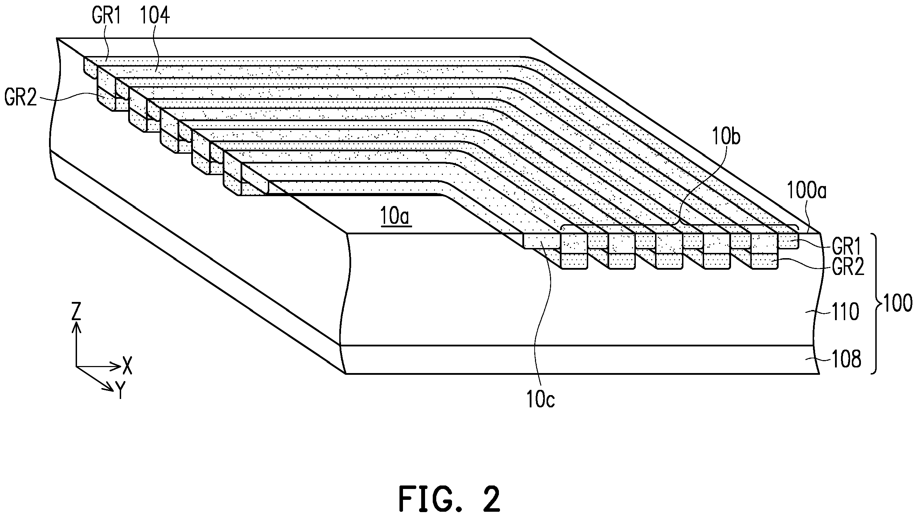

FIG. 2 is a schematic three-dimensional view of a silicon carbide power device according to a second embodiment of the disclosure, where the same or similar parts and components are represented by the same reference numerals as those in the first embodiment, and the relevant content of the same or similar parts and components is also as provided for the content of the first embodiment, and is not repeated herein.

Referring to FIG. 2, the silicon carbide power device of the second embodiment has the same active region 10a and the same termination region 10b as the first embodiment. In order to control the drift layer charge in the junction terminal accurately, the JTE region10c is disposed between the active region 10a and the termination region 10b, but the disclosure is not limited thereto. In another embodiment, the JTE region 10c may be omitted, so that the termination region 10b is directly connected to the active region 10a. The silicon carbide power device of the second embodiment includes the silicon carbide substrate 100, multiple first guard rings GR1, multiple second guard rings GR2, and the dielectric trench structures 104. Although FIG. 2 is a three-dimensional view, FIG. 2 only shows one corner of the silicon carbide power device. The actual size of the silicon carbide power device may be several times or hundreds of times larger than that in FIG. 2 and may extend along an X direction and a Y direction. The X direction and the Y direction are both horizontal directions.

Referring to FIG. 2 continuously, the silicon carbide substrate 100 is the first conductivity type, and the first guard ring GR1 and the second guard ring GR2 may be ion implantation regions with the second conductivity type. In an embodiment, the first conductivity type is the N-type, and the second conductivity type is the P-type. In another embodiment, the first conductivity type is the P-type, and the second conductivity type is the N-type. The aforementioned first guard ring GR1 is disposed on the surface 100a of the silicon carbide substrate 100 in the termination region 10b, and the second guard ring GR2 is disposed in the silicon carbide substrate 100 among the first guard rings GR1, for example, locating in the N- silicon carbide epitaxial layer 110. The first guard rings GR1 and the second guard rings GR2 are located on different horizontal planes, that is, the first guard rings GR1 and the second guard rings GR2 are at different heights in a Z direction (a vertical direction). The dielectric trench structures 104 are disposed above the second guard rings GR2 and are alternately arranged with the first guard rings GR1. A material of the dielectric trench structures 104 may be referred to the previous embodiment, and is not repeated herein.

Since the silicon carbide power devices in the above embodiments formed the guard rings with upper and lower layers distributed alternately, the ion implantation may reach deeper along vertical direction, and therefore the overall electric field distribution may be more uniform to improve the characteristic of the voltage endurance of the device without increasing the area occupied by the guard ring excessively and affect the active region and the JTE region of the device.

In order to verify the above effects, the following simulation experiments were conducted.
1) Single layer guard ring: The simulation object is a silicon carbide power device with a structure similar to FIG. 2 but with only a first layer guard ring and no second layer guard ring. The number of single layer guard rings is 14, and the N- silicon epitaxial layer is set to an epitaxial layer with a thickness of 15 µm and a doping concentration of 5.5e15 cm⁻³.
2) Double layer guard ring of the disclosure: The simulation object is a silicon carbide power device with the same structure as FIG. 2, the numbers of first layer guard rings are 14, 12, 10, and 8 respectively, and the numbers of second layer guard rings are 14, 12, 10, and 8 respectively. For example, the number of guard rings in Table 1 is 14, which means that the number of first layer guard rings is 14, the number of second layer guard rings is also 14, and so on. In addition, the dielectric trench structure in the simulated structure takes silicon oxide as an example.

The above structure was simulated by technology computer-aided design (TCAD) to conduct the simulation experiments, and the results are shown in Table 1 below.

**Table 1**

| | Single layer guard ring | Double layer guard ring of the disclosure | | | |
|---|---|---|---|---|---|
| Number of guard rings | 14 | 14 | 12 | 10 | 8 |
| Horizontal size in termination region (µm) | 79.4 | 105.4 | 90.4 | 73.8 | 58.6 (↓26%) |
| Breakdown voltage (V) | 2010.8 | 2243.8 | 2240.1 | 2231.5 | 2218.2 (↑11%) |

It can be seen from Table 1 that the double layer guard ring of the disclosure with the dielectric trench structure improves the overall voltage endurance effect. Moreover, although the double layer guard ring of the disclosure with 14 guard rings in a single layer may occupy more space, the breakdown voltage of the silicon carbide power device is much higher than that of the traditional device with only 14 guard rings in a single layer. The space occupied by the guard ring may be reduced by decreasing the number of guard rings. For example, when the numbers of guard rings of the first layer guard ring and the second layer guard ring are decreased to less than 10, the guard rings occupy less space than the traditional guard ring structure which has a design with 14 guard rings in the single layer, but the voltage endurance of the device is more than 10% higher than that of the traditional guard ring structure. Therefore, the structure of the disclosure may reduce the area occupied by the guard rings and may improve the voltage endurance effect.

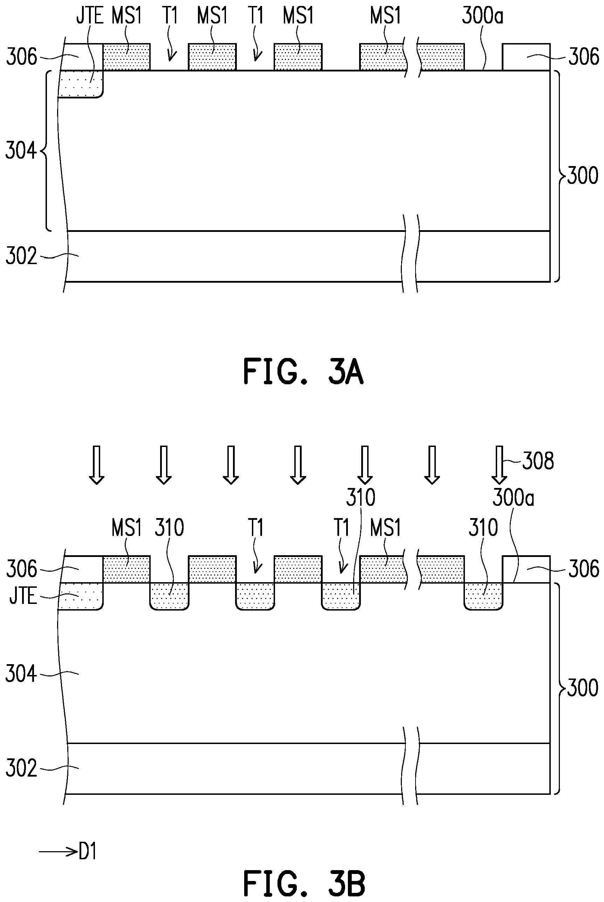

FIG. 3A to FIG. 3J are schematic cross-sectional views of a manufacturing process of a silicon carbide power device according to a third embodiment of the disclosure.

Referring to FIG. 3A at first, a silicon carbide substrate 300 is provided. The silicon carbide substrate 300 may be composed of an N+ silicon carbide substrate 302 and an N- silicon carbide epitaxial layer 304 formed thereon, but the disclosure is not limited thereto. Afterwards, a first mask layer MS1 is formed on the surface 300a of the silicon carbide substrate 300. The first mask layer MS1 has multiple first trenches T1 exposing part of the surface 300a, and the process of forming the first mask layer MS 1 requires a photomask process. Before the first mask layer MS1 is formed, the JTE region may be first formed in the silicon carbide substrate 300, and then a protective layer 306 is formed on the silicon carbide substrate 300 to cover the JTE region and other parts that do not form the guard rings.

Later, referring to FIG. 3B, an ion implantation process 308 may be used to form multiple first ion implantation regions 310 in the exposed surface 300a. Therefore, the first ion implantation regions 310 are formed in the N- silicon carbide epitaxial layer 304 and are distributed on the surface 300a of the silicon carbide substrate 300 along the horizontal direction D1. The ion implantation process 308 may adopt a general multi-step ion implantation process, for example, adopting two or more than three steps of the ion implantation process with an energy of 300 keV~550 keV and a dopant concentration of 0.7E13 cm⁻³~1.3E13 cm⁻³, but the disclosure is not limited thereto.

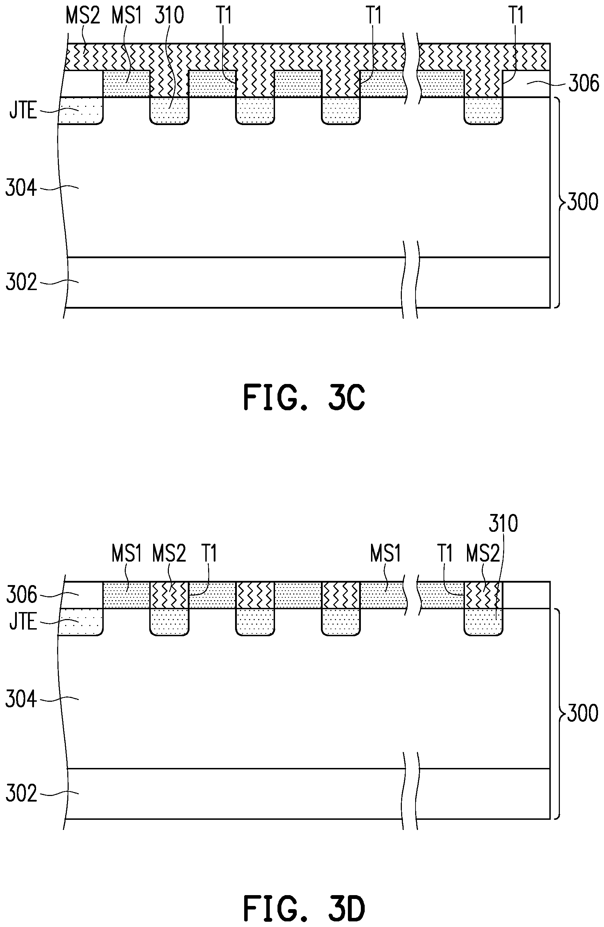

Next, referring to FIG. 3C, a second mask layer MS2 filling the first trenches T1 is formed on the first mask layer MS1, where the second mask layer MS2 and the silicon carbide substrate 300 have etch selectivity, and the first mask layer MS1 and the second mask layer MS2 have etch selectivity. "Etch selectivity" in this article refers to the ratio of etch rates of different materials to the same etching solution (condition). Therefore, having etch selectivity between a certain layer and another layer means that the two have different etch rates under the same etching condition. In addition, the second mask layer MS2 and the protective layer 306 also have etch selectivity.

Afterwards, referring to FIG. 3D, part of the second mask layer MS2 is removed until the first mask layer MS 1 is exposed, where the method of removing part of the second mask layer MS2 includes an etching back process or a chemical mechanical planarization (CMP) process. Therefore, the second mask layer MS2 may self-align among the first mask layers MS 1 and may be located directly above the first ion implantation regions 310.

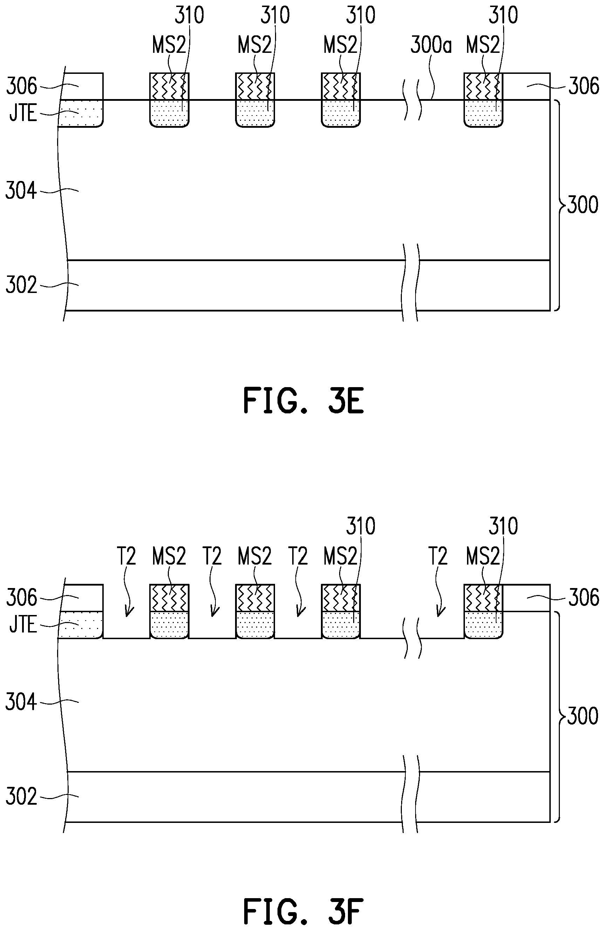

Next, referring to FIG. 3E, the first mask layer MS1 in FIG. 3D is completely removed, leaving the second mask layer MS2 to expose the surface 300a located among the first ion implantation regions 310. At the same time, the protective layer 306 still covers the JTE region and other parts that do not form a guard ring.

Later, referring to FIG. 3F, the second mask layer MS2 is used as an etch mask to remove the exposed surface 300a to form multiple self-aligned second trenches T2 among the first ion implantation regions 310.

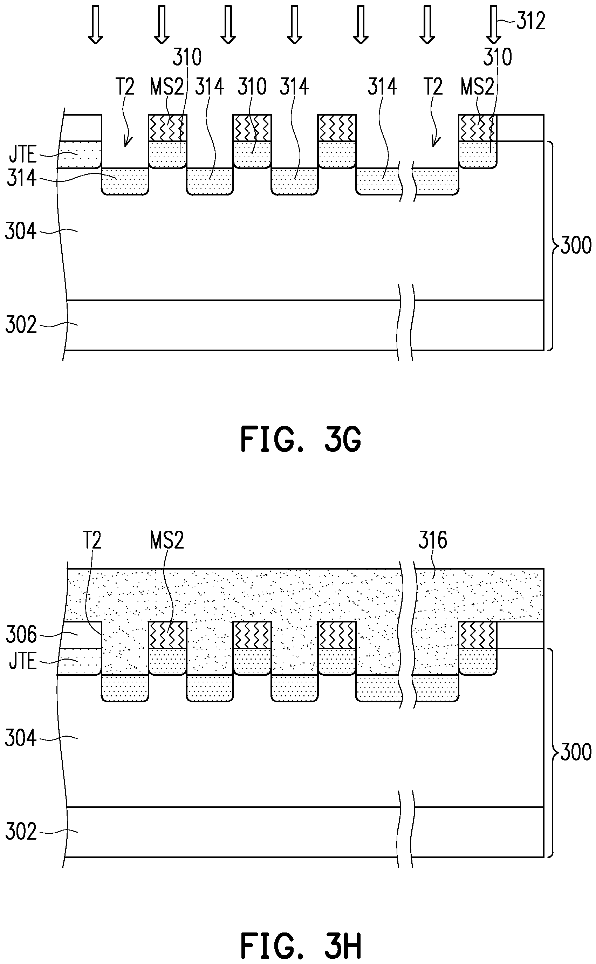

Afterwards, referring to FIG. 3G, an ion implantation process 312 may be used to form multiple second ion implantation regions 314 in the silicon carbide substrate 300 at bottoms of the second trenches T2. Therefore, the second ion implantation region 314 is formed in the N-silicon carbide epitaxial layer 304. The ion implantation process 312 may adopt a multi-step ion implantation process, for example, adopting two or more than three steps of the ion implantation with an energy of 700 keV~950 keV and a dopant concentration of 0.7E13 cm-3~1.3E13 cm⁻³, but the disclosure is not limited thereto. Since there is no need to use a high energy implantation machine when the energy forming the second ion implantation region 314 is below 1000 keV, the manufacturing costs may be reduced.

Subsequently, referring to FIG. 3H, in order to fill the dielectric material 316 in the second trenches T2, the dielectric material 316 may be first deposited on the second mask layer MS2, so that the dielectric material 316 fills the second trenches T2. In an embodiment, the dielectric material 316 includes a high-k material. In another embodiment, the dielectric material 316 includes an oxide or nitride. Moreover, for the subsequent step of removing the second mask layer MS2, the second mask layer MS2 and the dielectric material 316 preferably have etch selectivity.

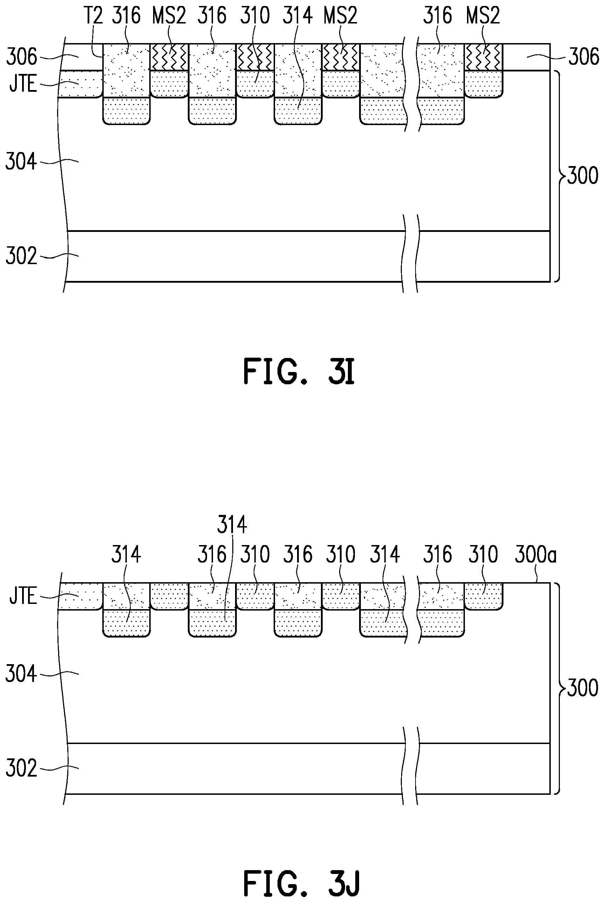

Afterwards, referring to FIG. 3I, the dielectric material 316 is planarized until the second mask layer MS2 is exposed.

Next, referring to FIG. 3J, the second mask layer MS2 is completely removed, and the protective layer 306 may be removed, but the disclosure is not limited thereto. In another embodiment, the protective layer 306 may be removed at the end. After the second mask layer MS2 is removed, the dielectric material 316 other than the surface 300a of the silicon carbide substrate 300 is removed.

In the method of the third embodiment, the etching of the second trenches T2 may use the first mask layer MS1 formed by the photomask process originally used for the first ion implantation regions 310 and use the characteristic of etch selectivity to complete the self-aligned second mask layer MS2 with different materials after the ion implantation process 308. Therefore, compared with a process of a single layer ion implantation region (or the guard ring), the process of the disclosure does not need to use an additional photomask.

In summary, the disclosure provides a manufacturing technology for the silicon carbide device. The silicon carbide device using this manufacturing technology may be widely used in electric vehicles, charging piles, and green energy industries. This manufacturing technology may improve the voltage endurance of the device, reduce the space occupied by the guard ring, increase the overall area utilization of the device, and achieve the effects of simultaneously improving device performance and reducing costs.

Although the disclosure has been disclosed in the above embodiments, the embodiments are not intended to limit the disclosure. Persons skilled in the art may make some changes and modifications without departing from the spirit and scope of the disclosure. Therefore, the protection scope of the disclosure shall be defined by the appended claims.

## Claims

1. A silicon carbide power device having an active region (10a) and a termination region (10b), comprising:
a silicon carbide substrate (100, 300);
a plurality of first ion implantation regions (102, 310), distributed on a surface (100a, 300a) of the silicon carbide substrate (100, 300) in the termination region (10b);
a plurality of dielectric trench structures (104), disposed in the silicon carbide substrate (100, 300) among the plurality of first ion implantation regions (102, 310), so that the plurality of dielectric trench structures (104) and the plurality of first ion implantation regions (102, 310) are alternately arranged along a horizontal direction (D1); and
a plurality of second ion implantation regions (106, 314), respectively disposed at bottoms of the plurality of dielectric trench structures (104).

2. The silicon carbide power device according to claim 1, wherein the plurality of first ion implantation regions (102, 310) and the plurality of second ion implantation regions (106, 314) are located on different horizontal planes.

3. The silicon carbide power device according to claim 1, wherein a material of the plurality of dielectric trench structures (104) comprises a high-k dielectric material, and a material of the plurality of dielectric trench structures (104) comprises an oxide or a nitride.

4. The silicon carbide power device according to claim 1, wherein the silicon carbide substrate (100, 300) is a first conductivity type, and the plurality of first ion implantation regions (102, 310) and the plurality of second ion implantation regions (106, 314) are a second conductivity type.

5. The silicon carbide power device according to claim 1, further comprising a junction termination extension region between the active region (10a) and the termination region (10b).

6. A silicon carbide power device having an active region (10a) and a termination region (10b), comprising:
a silicon carbide substrate (100, 300);
a plurality of first guard rings (GR1), disposed on a surface (100a, 300a) of the silicon carbide substrate (100, 300) in the termination region (10b);
a plurality of second guard rings (GR2), disposed in the silicon carbide substrate (100, 300) among the plurality of first guard rings (GR1), wherein the plurality of first guard rings (GR1) and the plurality of second guard rings (GR2) are located on different horizontal planes; and
a plurality of dielectric trench structures (104), disposed above the plurality of second guard rings (GR2) and alternately arranged with the plurality of first guard rings (GR1).

7. The silicon carbide power device according to claim 6, wherein the silicon carbide substrate (100, 300) is a first conductivity type, and the plurality of first guard rings (GR1) and the plurality of second guard rings (GR2) are ion implantation regions with a second conductivity type.

8. The silicon carbide power device according to claim 6, wherein a material of the plurality of dielectric trench structures (104) comprises a high-k dielectric material, and a material of the plurality of dielectric trench structures (104) comprises an oxide or a nitride.

9. The silicon carbide power device of claim 6, further comprising a junction termination extension region between the active region (10a) and the termination region (10b).

10. A manufacturing method of a silicon carbide power device, comprising:
providing a silicon carbide substrate (100, 300);
forming a first mask layer (MS1) on a surface (100a, 300a) of the silicon carbide substrate (100, 300), wherein the first mask layer (MS1) has a plurality of first trenches (T1) exposing part of the surface (100a, 300a);
forming a plurality of first ion implantation regions (102, 310) in the exposed surface;
forming a second mask layer (MS2) filling the plurality of first trenches (T1) on the first mask layer (MS1);
removing part of the second mask layer (MS2) until the first mask layer (MS1) is exposed;
removing the first mask layer (MS1) completely, leaving the second mask layer (MS2) to expose the surface among the plurality of first ion implantation regions (102, 310);
using the second mask layer (MS2) as an etch mask, and removing the exposed surface to form a plurality of self-aligned second trenches (T2) among the plurality of first ion implantation regions (102, 310);
forming a plurality of second ion implantation regions (106, 314) in the silicon carbide substrate (100, 300) at bottoms of the plurality of second trenches (T2); and
filling a dielectric material in the plurality of second trenches (T2).

11. The manufacturing method of the silicon carbide power device according to claim 10, wherein the first mask layer (MS1) and the second mask layer (MS2) have an etch selectivity.

12. The manufacturing method of the silicon carbide power device according to claim 10, wherein the second mask layer (MS2) and the dielectric material have an etch selectivity, and the second mask layer (MS2) and the silicon carbide substrate (100, 300) have an etch selectivity.

13. The manufacturing method of the silicon carbide power device according to claim 10, wherein the dielectric material comprises a high-k dielectric material, and the dielectric material comprises an oxide or a nitride.

14. The manufacturing method of the silicon carbide power device according to claim 10, wherein before forming the first mask layer (MS1), the method further comprising: forming a junction termination extension region in the silicon carbide substrate (100, 300).

15. The manufacturing method of the silicon carbide power device according to claim 10, wherein the method of removing part of the second mask layer (MS2) comprises an etching back process or a chemical mechanical planarization process.

16. The manufacturing method of the silicon carbide power device according to claim 10, wherein the step of filling the dielectric material in the plurality of second trenches (T2) comprises:
depositing the dielectric material on the second mask layer (MS2), so that the dielectric material fills the plurality of second trenches (T2);
planarizing the dielectric material until the second mask layer (MS2) is exposed;
removing the second mask layer (MS2) completely; and
removing the dielectric material other than the surface of the silicon carbide substrate (100, 300).
